# EUROPEAN PATENT APPLICATION

(11) **EP 3 037 872 A2**
(43) Date of publication of application: **29.06.2016**
(21) Application number: 15201503.8
(22) Date of filing: 21.12.2015
(51) Int. Cl.: G02F 1/1333, G02F 1/1345

(54) **DISPLAY DEVICE**

(30) Priority: 22.12.2014 KR 20140186129
(71) Applicant: Samsung Display Co., Ltd., Gyeonggi-do (KR)
(72) Inventor: Lee, Seongseok, 39295 Gyeongsangbuk-do (KR); Tsunekawa, Toru, 31471 Chungcheongnam-do (KR)
(74) Representative: Dr. Weitzel & Partner

(57) **Abstract**

A display device includes: a display panel (120); a flexible printed circuit board FPCB (128) attached to the display panel (120); and an intermediate frame (130) including a support portion (131) supporting the display panel (120) and a first side wall (133) extending from the support portion (131), wherein the intermediate frame (130) has an aperture (133h) in the first side wall (133) and includes at least a protrusion (133a) extending from the first side wall (133) into the aperture (133h), and at least a portion of the FPCB (128) is disposed inwardly of the protrusion (133a) and in the aperture (133h).

## Description

### BACKGROUND OF THE INVENTION

### Field of disclosure

Embodiments of the present invention relate to a display device having a narrow bezel.

### Description of the Related Art

Display devices are classified into liquid crystal display (LCD) devices, organic light emitting diode (OLED) display devices, plasma display panel (PDP) devices, electrophoretic display devices, and the like, based on a driving scheme of a display panel.

In order to drive a display device, a flexible printed circuit board (FPCB) that may be fabricated with a flexible sheet having a printed circuit pattern formed on an electrically conductive material, and may be bent and deformed with a high degree of freedom, in conformity to a cooperating surface, object or geometric shape, despite bearing electrical parts, such as a chip-on-film (COF) or a tape carrier package (TCP) is attached to a display panel along at least a side surface of the display panel.

In addition, a bezel portion covering an upper surface of a display panel to fix the display panel to a backlight unit, or the like, and an upper frame including a side wall portion of the display panel bent downwardly from the bezel portion to cover a side surface of the display panel are provided in the display device.

In display devices having the same size, an area of an actual screen thereof is increased as a width of the bezel portion is reduced, and thus, there is a growing demand for minimizing the width of the bezel.

Meanwhile, as the width of the bezel portion of the upper frame is reduced, the side wall portion of the upper frame is disposed to be relatively adhered to the display panel. As a result, external impacts or vibrations applied from the upper frame may be transmitted to an FPCB, thereby damaging the FPCB. Further, during a process of separating the upper frame from the display device for rework, the FPCB may be caught in the upper frame to thereby be escaped from the display panel.

It is to be understood that this background of the technology section is intended to provide useful background for understanding the technology and as such disclosed herein, the technology background section may include ideas, concepts or recognitions that were not part of what was known or appreciated by those skilled in the pertinent art prior to a corresponding effective filing date of subject matter disclosed herein.

### SUMMARY OF THE INVENTION

Aspects of embodiments of the present invention are directed to a display device capable of preventing external impacts or vibrations applied from an upper frame from being directly transmitted to a flexible printed circuit board (FPCB) while providing a narrow bezel simultaneously.

In addition, during a process of separating the upper frame from the display device for rework, the escape of the FPCB from the display panel due to being caught in the upper frame may be prevented.

According to an exemplary embodiment of the present invention, a display device includes: a display panel; a flexible printed circuit board (FPCB) attached to the display panel; and an intermediate frame including a support portion supporting the display panel and a first side wall extending from the support portion, wherein the intermediate frame has an aperture in the first side wall and includes at least a protrusion extending from the first side wall toward the aperture, and at least a portion of the FPCB is disposed inwardly of the protrusion and in the aperture.

The protrusion may have a thickness less than a thickness of the first side wall.

The protrusion may be disposed in the same plane as an outer surface of the first side wall.

The protrusion may be disposed in a different plane from an outer surface of the first side wall.

The protrusion may be parallel with respect to the outer surface of the first side wall.

The protrusion may have a predetermined angle with respect to the outer surface of the first side wall.

The protrusion may be in contact with at least a portion of the FPCB.

The protrusion may extend from the support portion and the first side wall toward the aperture.

The intermediate frame may further include a second side wall extending from the support portion and disposed more inwardly of the intermediate frame than the first side wall.

The display device may further include a lower frame disposed between the first and second side walls.

The FPCB may have a width less than a width of the aperture.

The protrusion may have a shape of one selected from the group consisting of a latch shape, a barb shape, a triangular shape, a trapezoidal shape, and a pentagonal shape.

At least a portion of the protrusion may be chamfered.

At least a portion of the protrusion may have a curved surface.

The intermediate frame may include at least a pair of protrusions extending from the first side wall toward the aperture while opposing one another.

The display device may further include an upper frame including a bezel portion covering an upper surface of the display panel and a side wall portion extending downwardly from the bezel portion to cover a side surface of the display panel.

The upper frame may include at least a bump extending from the side wall portion toward the intermediate frame.

The bump may be disposed in an area of the upper frame corresponding to the FPCB.

The bump may be disposed in an area of the upper frame corresponding to the aperture.

The bump may have a thickness the same as a thickness of the protrusion.

The bump may have a thickness greater than a thickness of the protrusion.

The bump may be in contact with the FPCB.

The upper frame may include a pair of bumps for each FPCB, and the bumps of a pair of bumps may be spaced apart from one another by a distance less than the width of the FPCB and may be spaced apart from one another by a distance greater than a width of an integrated circuit mounted on the FPCB.

According to another exemplary embodiment, a display device includes: a display panel; an FPCB attached to the display panel; an intermediate frame including a support portion supporting the display panel, a first side wall extending from the support portion, and a second side wall extending from the support portion and disposed more inwardly of the intermediate frame than the first side wall; and a lower frame disposed between the first and second side walls, wherein the intermediate frame has an aperture in the first side wall, at least a portion of the FPCB is disposed in the aperture, and the lower frame includes a protrusion having a hook shape extending toward the aperture.

At least a portion of the protrusion may be parallel with respect to an outer surface of the first side wall.

According to still another exemplary embodiment, a display device includes: a display panel; an FPCB attached to the display panel; and an intermediate frame including a support portion supporting the display panel and a first side wall extending from the support portion, wherein the intermediate frame has an aperture in the first side wall, the FPCB is disposed in the aperture, and at least a portion of the FPCB has a width greater than a width of the aperture.

The intermediate frame may further include a second side wall extending from the support portion to be perpendicular thereto and disposed more inwardly of the intermediate frame than the first side wall.

The display device may further include a lower frame disposed between the first and second side walls.

At least a portion of the FPCB may be disposed between the first side wall and the lower frame.

The foregoing is illustrative only and is not intended to be in any way limiting. In addition to the illustrative aspects, embodiments, and features described above, further aspects, embodiments, and features will become apparent by reference to the drawings and the following detailed description.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings, in which like reference symbols indicate the same or similar components, wherein:
FIG. 1 is an exploded perspective view illustrating a display device according to an exemplary embodiment of the present invention;
FIG. 2 is a cross-sectional view taken along line I-II of FIG. 1;
FIG. 3 is a partial perspective view illustrating the cross-section taken along line I-II of FIG. 1;
FIGS. 4 through 7 are partial perspective views illustrating protrusions according to other exemplary embodiments of the present invention, respectively;
FIGS. 8A and 8B are enlarged views illustrating a protrusion of an intermediate frame according to an exemplary embodiment of the present invention, FIG. 8A shows a front surface of the protrusion, and FIG. 8B shows a rear surface of the protrusion;
FIGS. 9 and 10 are enlarged views illustrating front surfaces of protrusions according to other exemplary embodiments of the present invention, respectively;
FIG. 11 is a view illustrating an example of a display device according to an exemplary embodiment of the present invention in which an upper frame is separated from a backlight unit in which a display panel is mounted, for ease of description;
FIG. 12 is an enlarged view illustrating portion "A" of FIG. 11;
FIGS. 13 through 15 are perspective views illustrating display devices according to other exemplary embodiments of the present invention, respectively;
FIGS. 16A through 16C are views illustrating a process of assembling a display device according to an exemplary embodiment of the present invention;
FIG. 17 is a plan view illustrating a display device according to an exemplary embodiment of the present invention;
FIG. 18 is a cross-sectional view taken along line III-IV of FIG. 17; and
FIGS. 19A through 19C are views illustrating a sequence for a process of assembling a display device according to another exemplary embodiment of the present invention.

### DETAILED DESCRIPTION OF THE INVENTION

Advantages and features of the present invention and methods for achieving them will be made clear from embodiments described below in detail with reference to the accompanying drawings. The present invention may, however, be embodied in many different forms and should not be construed as being limited to the embodiments set forth herein. Rather, these embodiments are provided so that this disclosure will be thorough and complete, and will fully convey the scope of the invention to those skilled in the art. The present invention is merely defined by the scope of the claims. Therefore, well-known constituent elements, operations and techniques are not described in detail in the embodiments in order to prevent the present invention from being obscurely interpreted. Like reference numerals refer to like elements throughout the specification.

Throughout the specification, when an element is referred to as being "connected" to another element, the element is "directly connected" to the other element, or "electrically connected" to the other element with one or more intervening elements interposed therebetween. It will be further understood that the terms "comprises," "comprising," "includes" and/or "including," when used in this specification, specify the presence of stated features, integers, steps, operations, elements, and/or components, but do not preclude the presence or addition of one or more other features, integers, steps, operations, elements, components, and/or groups thereof

It will be understood that, although the terms "first," "second," "third," and the like may be used herein to describe various elements, these elements should not be limited by these terms. These terms are only used to distinguish one element from another element. Thus, "a first element" discussed below could be termed "a second element" or "a third element," and "a second element" and "a third element" can be termed likewise without departing from the teachings herein.

All terminology used herein are merely used to describe embodiments of the inventive concept and may be modified according to the relevant art and the intention of an applicant. Therefore, the terms used herein should be interpreted as having a meaning that is consistent with their meanings in the context of the present disclosure, and is not intended to limit the invention.

Unless otherwise defined, all terms used herein (including technical and scientific terms) have the same meaning as commonly understood by those skilled in the art to which this invention pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the present specification.

Hereinafter, it will be assumed that a display device according to an exemplary embodiment of the present invention is a liquid crystal display (LCD) device. However, the display device according to the exemplary embodiment may also be applied to an organic light emitting diode (OLED) display device or a plasma display panel (PDP) device, in addition to an LCD device.

In addition, it will be assumed that the display device according to the exemplary embodiment includes an edge-type backlight unit; however, the display device according to the exemplary embodiment is not limited thereto, and may also include is a direct-type backlight unit or a corner-type backlight unit.

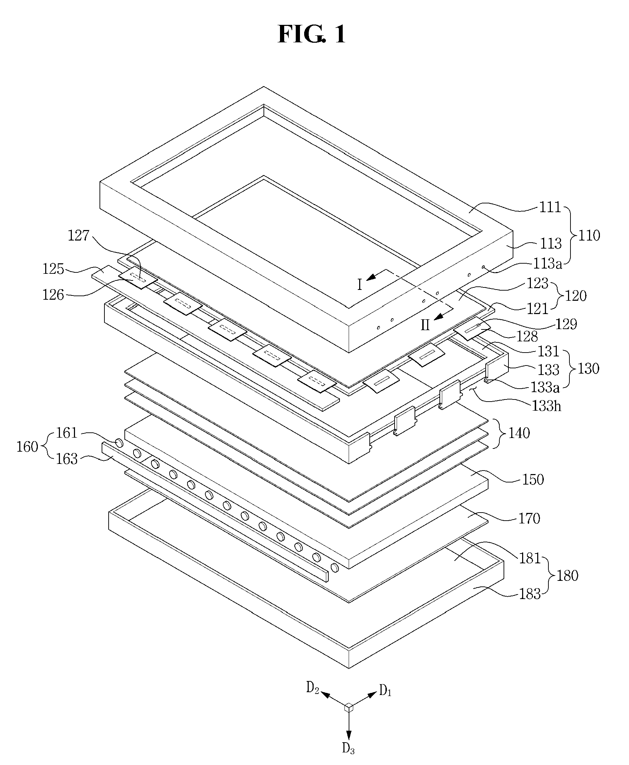

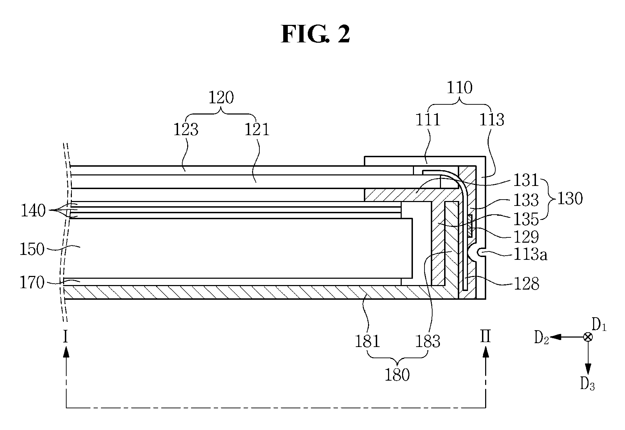

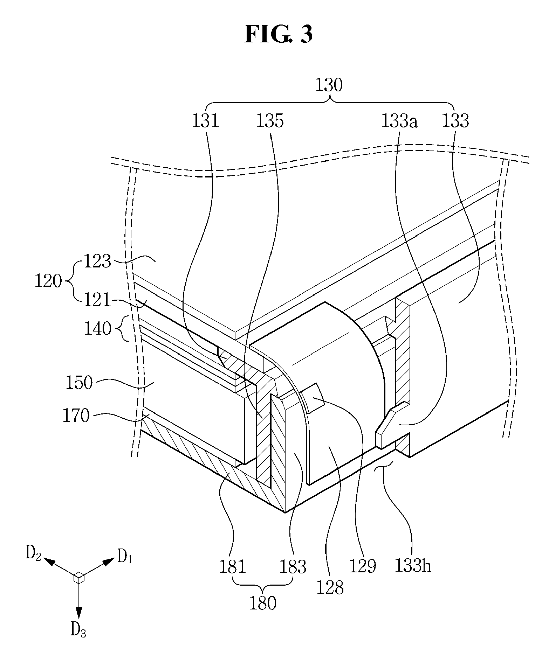

FIG. 1 is an exploded perspective view illustrating a display device according to an exemplary embodiment of the present invention; FIG. 2 is a cross-sectional view taken along line I-II of FIG. 1; and FIG. 3 is a partial perspective view illustrating the cross-section taken along line I-II of FIG. 1. For ease of description, an upper frame 110 will be omitted in FIG. 3.

Referring to FIGS. 1 and 2, the display device according to the exemplary embodiment may include an upper frame 110, a display panel 120, an intermediate frame 130, an optical sheet 140, a light guide plate 150, a light source unit 160, a reflective sheet 170, and a lower frame 180.

Hereinafter, the intermediate frame 130, the optical sheet 140, the light guide plate 150, the light source unit 160, the reflective sheet 170, the lower frame 180, and the like, will be referred to as a backlight unit.

The upper frame 110 may have an open window exposing an active area of the display panel 120 outwardly, and may be disposed to cover an upper surface and a side surface of the display panel 120.

The upper frame 110 may include a bezel portion 111 covering the upper surface of the display panel 120 and a side wall portion 113 bent downwardly from the bezel portion 111 to cover the side surface of the display panel 120.

The bezel portion 111 may fix the upper surface of the display panel 120 and may thereby prevent the display panel 120 from being escaped from the backlight unit. The side wall portion 113 may be fixed to the intermediate frame 130 and the lower frame 180 through hook coupling and/or screw coupling.

The upper frame 110 may have one or more bumps 113a in the side wall portion 113. The bump 113a may be disposed corresponding to a second flexible printed circuit board (FPCB) 128. The bump 113a may protrude toward the intermediate frame 130.

The bump 113a may press down the second FPCB 128 to thereby allow the second FPCB 128 to be closely adhered to the intermediate frame 130 during the process of coupling the backlight unit in which the display panel 120 is mounted to the intermediate frame 130.

The bump 113a may be formed by applying pressure to the side wall portion 113 of the upper frame 110 using a press process, or the like, during a manufacturing process of the upper frame 110, or may be formed by attaching an additional bump to an inner side of the side wall portion 113 facing the intermediate frame 130. Hereinafter, it is assumed that the bump 113a is formed by applying pressure to the side wall portion 113 of the upper frame 110.

The upper frame 110 may be formed of a metal material having rigidity such as stainless steel or a material having excellent heat dissipation properties such as aluminum (Al) or an Al alloy.

The display panel 120 may be provided as a quadrangular planar shape displaying an image by using light. The display panel 120 may include a first substrate 121, a second substrate 123 opposing the first substrate 121, and a liquid crystal layer (not illustrated) formed between the first and second substrates 121 and 123.

A driving circuit board 125 may be disposed in at least a side portion of the display panel 120. The driving circuit board 125 may provide various types of control signals and power signals for driving the display panel 120.

The display panel 120 and the driving circuit board 125 may be electrically connected to one another by one or more FPCBs, for example, FPCBs 126 and 128. The FPCBs 126 and 128 may be a chip on film (COF) or a tape carrier package (TCP), and the number of FPCBs may vary based on a size, a driving scheme, and the like, of the display panel 120.

The FPCBs 126 and 128 may be classified into a first FPCB 126 in which a data integrated circuit 127 is mounted and a second FPCB 128 in which a gate integrated circuit 129 is mounted.

One end of the first FPCB 126 may be connected to a data pad area of the first substrate 121, and the other end thereof may be connected to the driving circuit board 125. One end of the second FPCB 128 may be connected to a gate pad area of the first substrate 121.

The first FPCB 126 may include a plurality of metal wirings (not illustrated) disposed on a base film, such that a data signal and a control signal supplied from the driving circuit board 125 are supplied to the data integrated circuit 127 and an image signal output from the data integrated circuit 127 is supplied to each data line.

The second FPCB 128 may include a plurality of metal wirings (not illustrated) disposed on a base film, such that a gate control signal supplied from the driving circuit board 125 is supplied to the gate integrated circuit 129 and a gate-on voltage output from the gate integrated circuit 129 is supplied to each gate line.

The intermediate frame 130 may support a lower surface of the display panel 120 and may accommodate the optical sheet 140, the light guide plate 150, the light source unit 160, the reflective sheet 170, and the like, therein.

The optical sheet 140 may be disposed on the light guide plate 150, and may serve to diffuse or collect light transmitted from the light guide plate 150. The light guide plate 150 may uniformly supply light supplied from the light source unit 160 to the display panel 120. The light source unit 160 may include a light source 161 and a circuit board 163 on which the light source 161 is disposed. The lower frame 180 may include a bottom portion 181 and a side wall portion 183 extending from the bottom portion 181.

The intermediate frame 130 may have a polygonal frame shape having an opening formed therein. For example, the intermediate frame 130 may have a quadrangular frame shape having an opening formed therein. The intermediate frame 130 may be formed as a single frame; however, may be formed to include a plurality of portions thereof to be subsequently assembled therefrom, as necessary. The intermediate frame 130 may be formed of a flexible material such as plastic, and may be formed through an injection molding process, or the like.

Referring to FIG. 3, the intermediate frame 130 may include a support portion 131 supporting the lower surface of the display panel 120, a first side wall 133 extending from the support portion 131 to be perpendicular or inclined thereto, and a second side wall 135 extending from the support portion 131 to be perpendicular or inclined thereto, and substantially parallel with respect to the first side wall 133. The second side wall 135 may be disposed more inwardly of the intermediate frame 130 than the first side wall 133. Hereinafter, for ease of description, a width direction, a length direction, and a thickness direction will be referred to as D1, D2, and D3 based on the upper frame 110, respectively.

An edge portion of the display panel 120 on the support portion 131 may be a non-display area in which an image is not displayed. In order to substantially reduce such a non-display area, a width of the support portion 131 may be substantially reduced. As the width of the support portion 131 is reduced, the edge portion of the display panel 120 may be supported by the second side wall 135. That is, the second side wall 135 and the display panel 120 may be disposed to overlap one another.

Since the side wall portion 183 of the lower frame 180 is disposed between the first and second side walls 133 and 135, the first side wall 133 may be disposed outwardly of the side wall portion 183 of the lower frame 180, and the second side wall 135 may be disposed inwardly of the side wall portion 183 of the lower frame 180.

The intermediate frame 130 may include an aperture 133h in the first side wall 133. The aperture 133h may be formed by a portion of the first side wall 133 being removed, or by a discontinuous formation of the first side wall 133. Accordingly, the aperture 133h may expose a portion of the support portion 131 and a portion of the side wall portion 183 of the lower frame 180.

The portions of the support portion 131 and the side wall portion 183 of the lower frame 180 exposed by the aperture 133h may be in contact with the second FPCB 128, and at least portions of the support portion 131 and the side wall portion 183 in contact with the second FPCB 128 may be chamfered or may have curved shapes, respectively.

The intermediate frame 130 may include one or more protrusions 133a extending toward the aperture 133h from the first side wall 133. The protrusion 133a may have a thickness less than a thickness of the first side wall 133. The protrusion 133a may be in contact with at least a portion of the second FPCB 128.

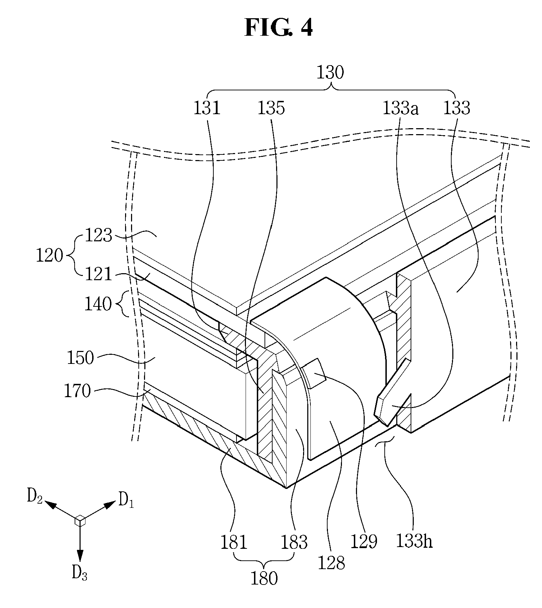

FIGS. 4 through 7 are partial perspective views illustrating protrusions according to other exemplary embodiments of the present invention, respectively. A description pertaining to protrusions according to other exemplary embodiments including content identical to that included in the description of the protrusion according to the exemplary embodiment will be omitted for conciseness. In addition, the upper frame will be omitted in FIGS. 4 through 7 for ease of description.

Referring to FIG. 4, the protrusion 133a may extend from the first side wall 133 in a direction non-parallel with respect to the width direction D1, especially with respect to the length direction of the first side wall 133 from which the protrusion 133a extends. For example, the direction in which the protrusion 133a extends may diverge from the width direction D1 to have predetermined angles with respect thereto.

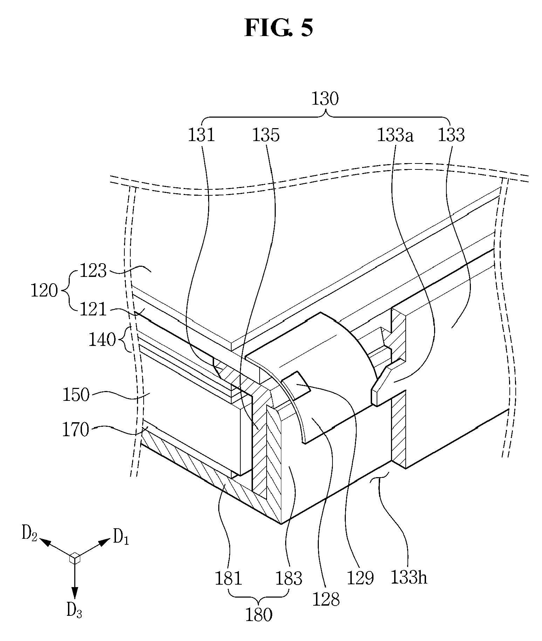

Referring to FIG. 5, since the protrusion 133a is used to fix the second FPCB 128, a position of the protrusion 133a in the first side wall 133 from which the protrusion 133a extends may vary based on a length of the second FPCB 128 disposed in the aperture 133h.

For example, as illustrated in FIG. 5, in a case in which a length of the second FPCB 128 is relatively short, the position of the protrusion 133a in the first side wall 133 from which the protrusion 133a extends may be disposed relatively upwardly based on the length direction D2 for example in the upper half of the first side wall 133, which may be the half at which the display panel 120 is positioned.

In particular, the protrusion 133a may extend from a position in the first side wall 133 at which an end of the second FPCB 128 is able to be fixed to the protrusion 133a. Accordingly, the protrusion 133a may be disposed to have a height less than a height of the gate integrated circuit 129 mounted on the second FPCB 128.

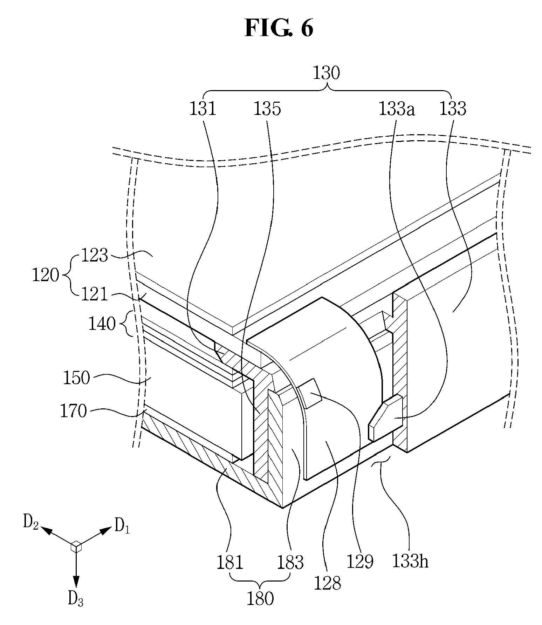

The protrusion 133a may be disposed in a plane the same as an outer surface of the first side wall 133 as illustrated in FIGS. 3 through 5, which means that the outer surface of the protrusion 133a may be flush with the outer surface of the first side wall 133, or may be disposed in a plane different from the outer surface of the first side wall, which means that there is a step or transition between the outer surface of the protrusion 133a and the outer surface of the first side wall 133. In particular, as illustrated in FIG. 6, the protrusion 133a may be disposed more inwardly of the intermediate frame 130 than the outer surface of the first side wall 133 based on the thickness direction D3.

In a case in which the protrusion 133a is disposed more outwardly of the intermediate frame 130 than the outer surface of the first side wall 133 based on the thickness direction D3, a width of a bezel may be increased therein due to the protrusion 133a, and thus, it may be difficult to provide a display device having a narrow bezel.

Accordingly, in order to provide such a display device having a narrow bezel, the protrusion 133a may be disposed in the same plane as the outer surface of the first side wall 133, or may be disposed more inwardly of the intermediate frame 130 than the outer surface of the first side wall 133 based on the thickness direction D3.

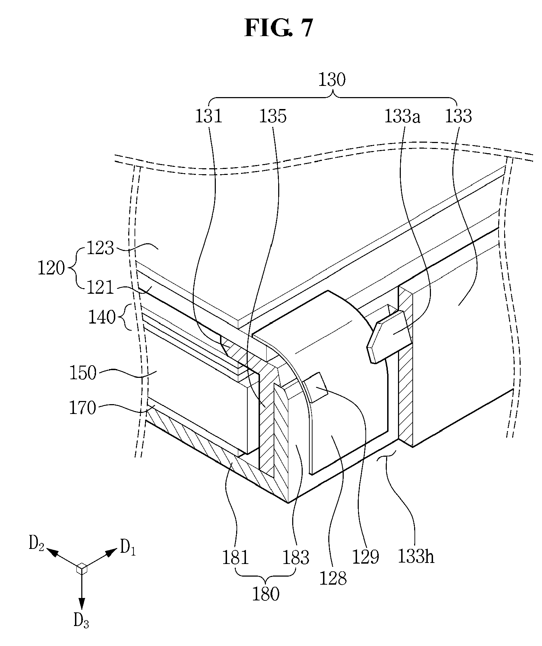

Referring to FIG. 7, the intermediate frame 130 may include the support portion 131 and one or more protrusions 133a extending from the first side wall 133 toward the aperture 133h. That is, the protrusion 133a may have a predetermined angle with respect to the outer surface of the first side wall 133.

For example, at least a portion of the support portion 131 exposed by the aperture 133h may be chamfered. The support portion 131 and the protrusion 133a extending from the first side wall 133 may be disposed to be substantially parallel with respect to the chamfered portion of the support portion 131.

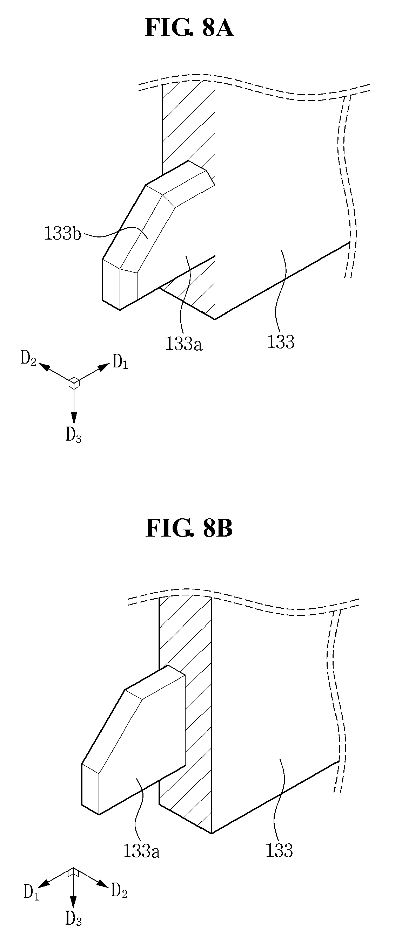

FIG. 8A is a view illustrating a front surface of the protrusion 133a contacting a FPCB according to the exemplary embodiment of the present invention; and FIG. 8B is a view illustrating a rear surface of the protrusion 133a according to the exemplary embodiment of the present invention. For ease of description, the front surface of the protrusion 133a refers to a surface facing the side wall portion 183 of the lower frame 180 and contacting a FPCB, and the rear surface of the protrusion 133a refers to a surface facing the side wall portion 113 of the upper frame 110.

Referring to FIGS. 8A and 8B, the protrusion 133a according to the exemplary embodiment may have a latch shape. At least a portion of a front edge portion 133b of a front surface of the protrusion 133a contacting a FPCB may be chamfered allowing for the easy accommodation of the FPCB inwardly thereof, and the rear surface of the protrusion 133a may not be chamfered in order to stably fix the accommodated FPCB thereto.

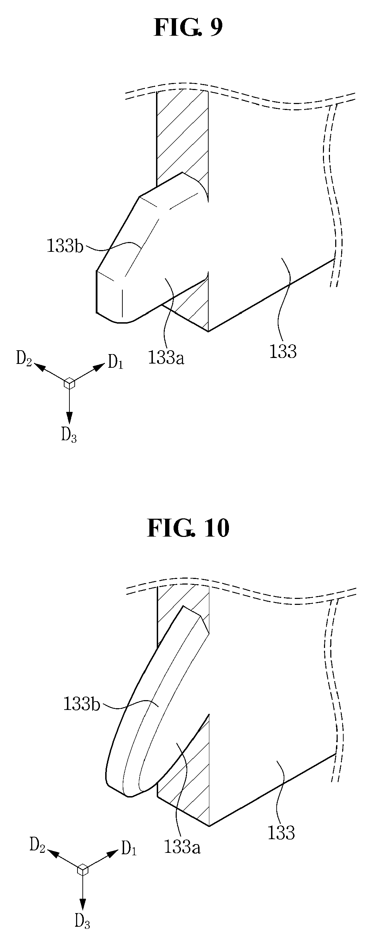

FIGS. 9 and 10 are enlarged views illustrating protrusions according to other exemplary embodiments of the present invention, respectively.

Referring to FIG. 9, the protrusion 133a according to the other exemplary embodiment may have a latch shape. At least a portion of a front edge portion 133b of a front surface of the protrusion 133a contacting a FPCB may have a curved shape such that an FPCB is readily accommodated therein.

Referring to FIG. 10, a protrusion 133a according to another exemplary embodiment may have a barb shape. At least a portion of a front edge portion 133b of a front surface of the protrusion 133a contacting a FPCB may be chamfered or may have a curved shape allowing for the easy accommodation of an FPCB inwardly thereof. An angle between the lengthwise axis of the front edge portion 133b and the contacting surface of the first side wall 133 or the surface of the first side wall 133 from which the protrusion 133a extends being an acute angle. In addition, the protrusion 133a may have a triangular shape, a trapezoidal shape, a pentagonal shape, or the like.

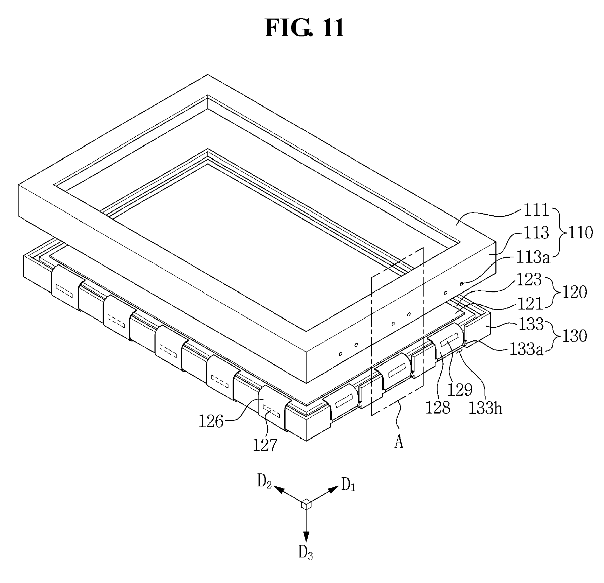

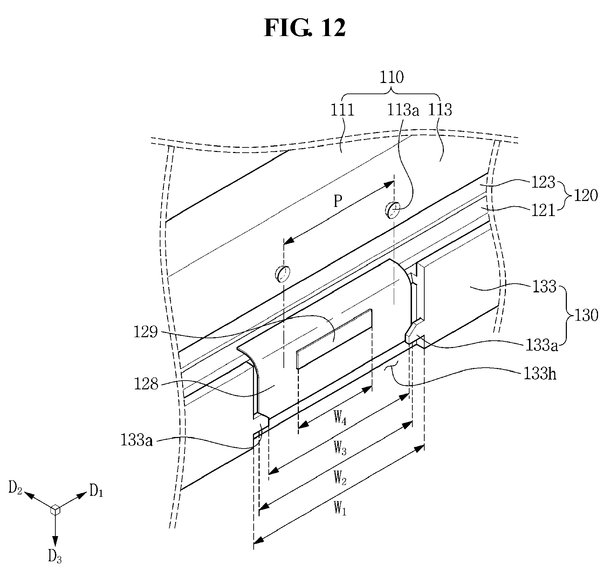

FIG. 11 is a view illustrating an example of a display device according to an exemplary embodiment of the present invention in which an upper frame is separated from a backlight unit in which a display panel is mounted, for ease of description; and FIG. 12 is an enlarged view illustrating portion "A" of FIG. 11.

Referring to FIGS. 11 and 12, the display device according to the exemplary embodiment may include the upper frame 110, the display panel 120, and the intermediate frame 130.

The upper frame 110 may include the bezel portion 111 covering the upper surface of the display panel 120 and the side wall portion 113 bent downwardly from the bezel portion 111 to cover the side surface of the display panel 120. The upper frame 110 may have the one or more bumps 113a on the side wall portion 113.

The display panel 120 may include the first and second substrates 121 and 123, and the first FPCB 126 on which the data integrated circuit 127 is mounted and the second FPCB 128 on which the gate integrated circuit 129 is mounted may be attached to the display panel 120.

The intermediate frame 130 may include the first side wall 133 having the aperture 133h, and the one or more protrusions 133a extending from the first side wall 133 toward the aperture 133h. The protrusions 133a may include a pair of protrusions 133a formed at both ends of the aperture 133h, respectively, so as to extend from the first side wall 133 toward the aperture 133h while opposing one another.

Although FIG. 11 illustrates an example in which the display panel 120 includes three second FPCBs 128 attached to a side thereof, and the intermediate frame 130 includes three apertures 133h corresponding to the second FPCBs 128, respectively, the number of the apertures 133h is not limited to the illustrated example, and the number of the apertures 133h to be included in the intermediate frame 130 may be provided in various manners based on the number of the second FPCBs 128 to be attached to the display panel 120.

The second FPCB 128 may be disposed in the aperture 133h of the intermediate frame 130. A width W2 of the second FPCB 128 may be less than a width W1 of the aperture 133h, and may be greater than an interval W3 between the protrusions 133a. The interval W3 between the protrusions 133a may need to have an appropriate length to allow the second FPCB 128 to be readily accommodated in the aperture 133h and then to be stably supported by the protrusions 133a.

The upper frame 110 may have a pair of bumps 113a at a position in the upper frame 110, corresponding to a single second FPBC 128. As illustrated in FIG. 12, in a case in which the gate integrated circuit 129 is disposed on one surface of the second FPCB 128, an interval P between the pair of bumps 113a may be less than the width W2 of the second FPCB 128 and may be greater than a width W4 of the gate integrated circuit 129 mounted on the second FPCB 128. On the other hand, in a case in which the gate integrated circuit 129 is disposed on the other surface of the second FPCB 128, the interval P between the pair of bumps 113a may be less than the width W2 of the second FPCB 128.

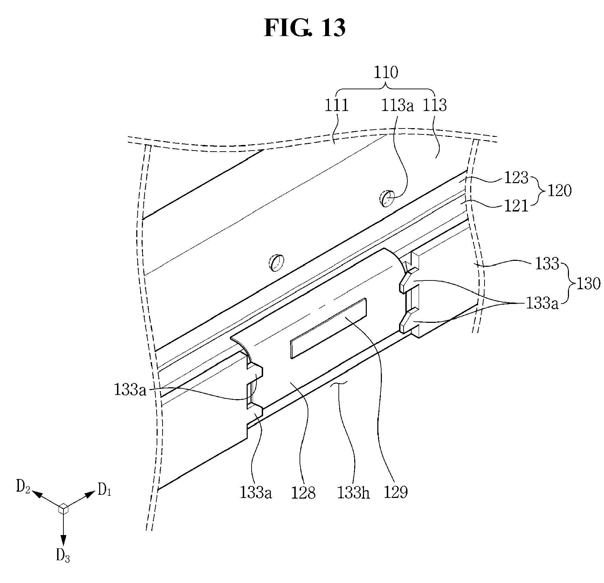

FIGS. 13 through 15 are perspective views illustrating display devices according to other exemplary embodiments of the present invention, respectively. A description pertaining to display devices according to other exemplary embodiments including content identical to that included in the description of the display device according to the exemplary embodiment will be omitted for conciseness.

Referring to FIG. 13, an intermediate frame 130 may include a first side wall 133 having an aperture 133h, and two protrusions 133a extending from the first side wall 133 toward the aperture 133h. The protrusion 133a may include two pairs of protrusions formed at both ends of the aperture 133h, respectively, to extend from the first side wall 133 toward the aperture 133h while opposing one another.

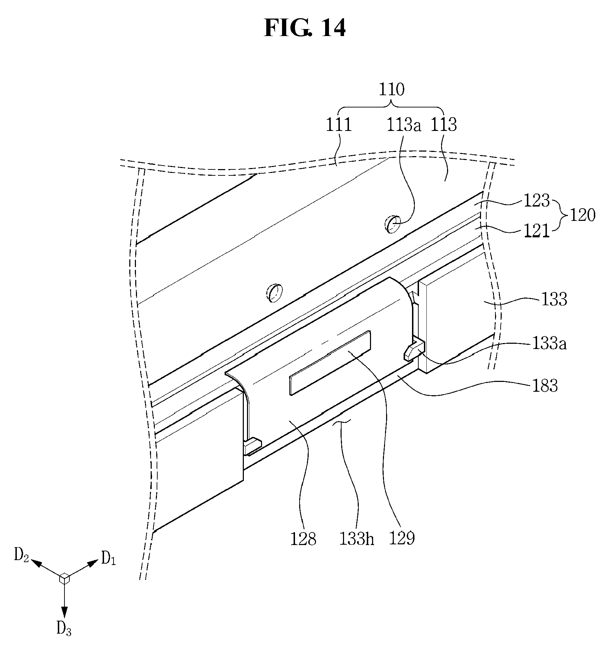

Referring to FIG. 14, a protrusion 133a may protrude from a side wall portion 183 of a lower frame to have a hook shape. In this case, at least a portion of the protrusion 133a may be substantially parallel with respect to a first side wall 133. Preferably, this portion is attached to the side wall portion 183 via a further portion extending perpendicular or with an angle from the side wall portion 183. In addition, the protrusion 133a may be disposed more inwardly of the intermediate frame 130 than an outer surface of the first side wall 133 based on the thickness direction D3, i.e. a direction perpendicular on the outer surface of the side wall portion 183. In a case in which the protrusion 133a is disposed more outwardly of the intermediate frame 130 than the outer surface of the first side wall 133 based on the thickness direction D3, a width of a bezel may be increased therein due to the protrusion 133a, and thus, it may be difficult to provide a display device having a narrow bezel. Accordingly, in order to provide such a display device having a narrow bezel, the protrusion 133a may protrude onto and especially not outside of a plane the same as the outer surface of the first side wall 133, or may protrude inwardly of the outer surface of the first side wall 133 based on the thickness direction D3.

Although FIG. 14 illustrates the protrusion 133a as having the hook shape, the shape of the protrusion 133a is not limited thereto, and may have various protruding shapes aside from the hook shape.

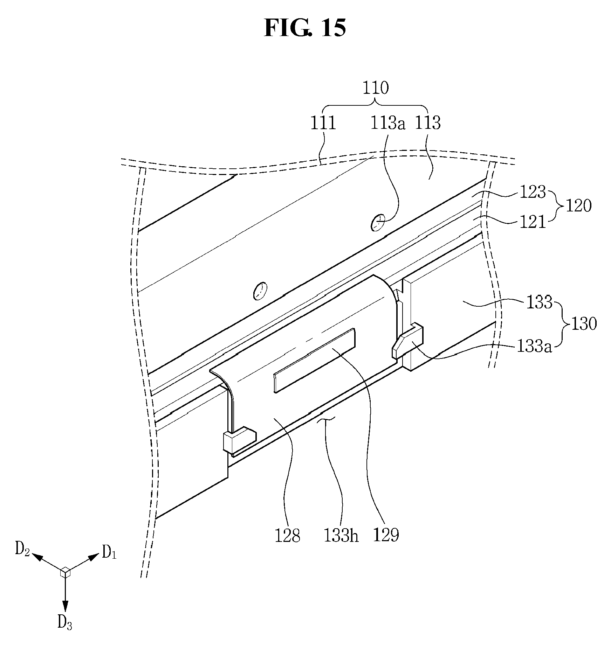

Referring to FIG. 15, a protrusion 133a may protrude from an outer surface of a first side wall 133 to have a hook shape. In this case, at least a portion of the protrusion 133a may be substantially parallel with respect to the first side wall 133. Preferably, this portion is attached to the outer surface of the first side wall 133 via a further portion extending perpendicular or with an angle from the outer surface of the first side wall 133. In this instance, since the protrusion 133a is disposed more outwardly of the intermediate frame 130 than the outer surface of the first side wall 133 based on the thickness direction D3, a width of a bezel may be increased therein due to the protrusion 133a.

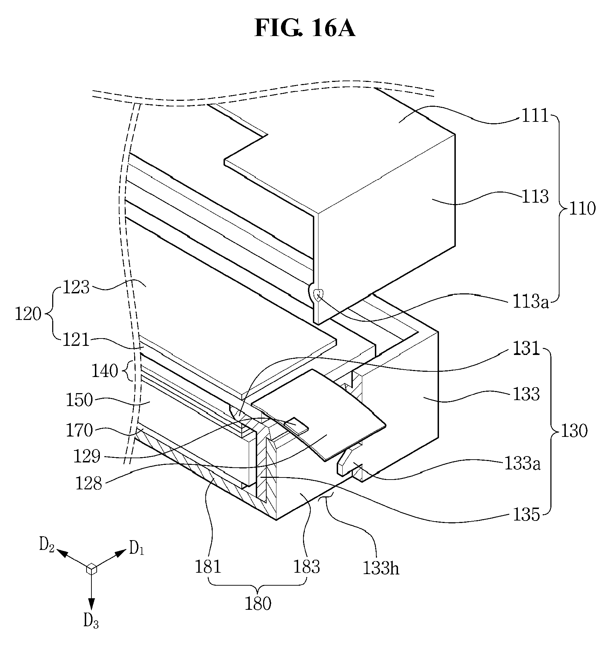

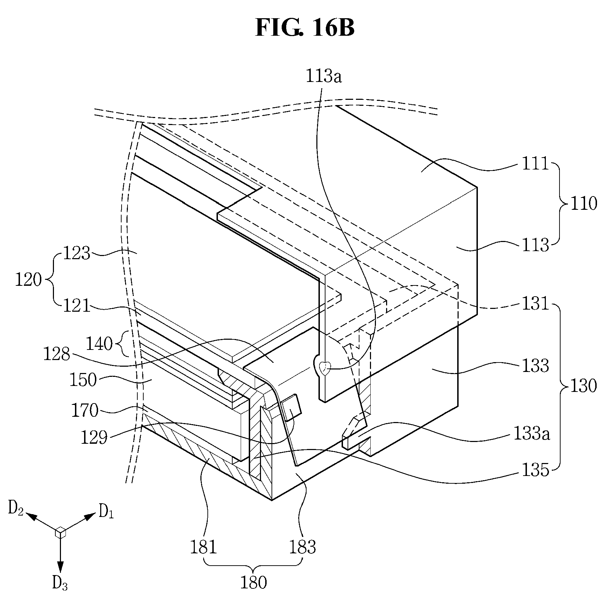

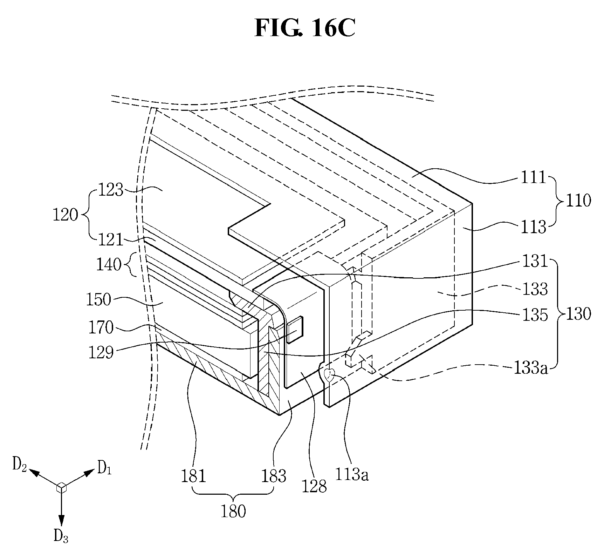

FIGS. 16A through 16C are views illustrating a process of assembling a display device according to an exemplary embodiment of the present invention.

Referring to FIGS. 16A through 16C, the display panel 120 may be mounted on the support portion 131 of the intermediate frame 130, and the upper frame 110 covering the upper surface and the side surface of the display panel 120 may be coupled to the backlight unit in which the display panel 120 is mounted.

At the time of coupling of the upper frame 110 to the backlight unit, the second FPCB 128 may be pressed down toward the intermediate frame 130 by the bump 113a formed in the side wall portion 113 of the upper frame 110. The second FPCB 128 may be formed of a film material having predetermined elasticity such as a COF or a TCP. Accordingly, when pressed down by the bump 113a, the second FPCB 128 may undergo a temporary elastic deformation to thereby be readily accommodated inwardly of the protrusion 133a of the intermediate frame 130.

Subsequently to the accommodation inwardly of the protrusion 133a, the second FPCB 128 may be restored to an original form thereof to be fixed by the protrusion 133a.

Since the protrusion 133a of the intermediate frame 130 is disposed between the second FPCB 128 and the upper frame 110, external impacts or vibrations applied from the upper frame 110 may not be directly transmitted to the second FPCB 128. In addition, since the protrusion 133a of the intermediate frame 130 fixes the second FPCB 128, during a process of separating the upper frame 110 from the display device for rework, the escape of the second FPCB 128 from the display device along with the upper frame 110 may be prevented.

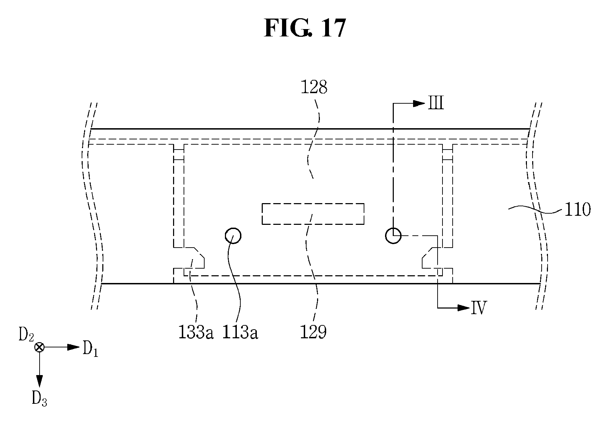

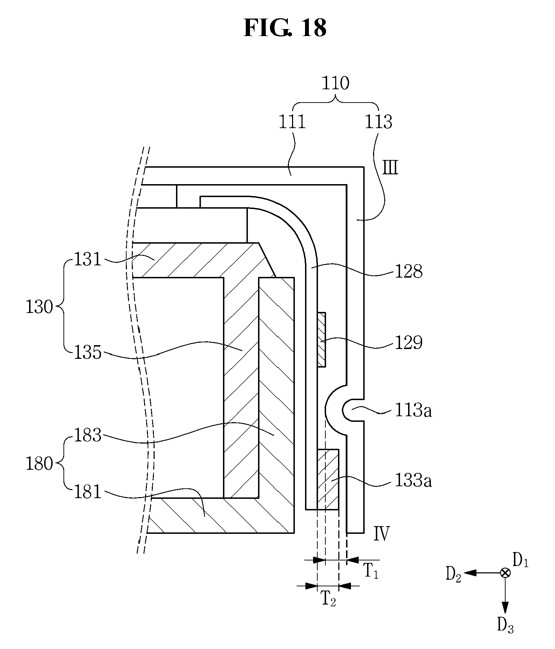

FIG. 17 is a plan view illustrating a display device according to an exemplary embodiment of the present invention; and FIG. 18 is a cross-sectional view taken along line III-IV of FIG. 17. FIGS. 17 and 18 are views illustrating an example in which the upper frame 110 is fully coupled to the backlight unit in which the display panel 120 is mounted.

Referring to FIGS. 17 and 18, the bump 113a may be disposed not to overlap the gate integrated circuit 129 mounted on the second FPCB 128 or the protrusion 133a.

In particular, since the bump 113a needs to provide elastic deformability allowing for the accommodation of the second FPCB 128 inwardly of the protrusion 133a, the bump 113a may be disposed adjacent to the protrusion 133a.

In addition, a thickness T1 of the bump 113a may be equal to or greater than a thickness T2 of the protrusion 133a. Accordingly, the bump 113a may be in contact with the second FPCB 128.

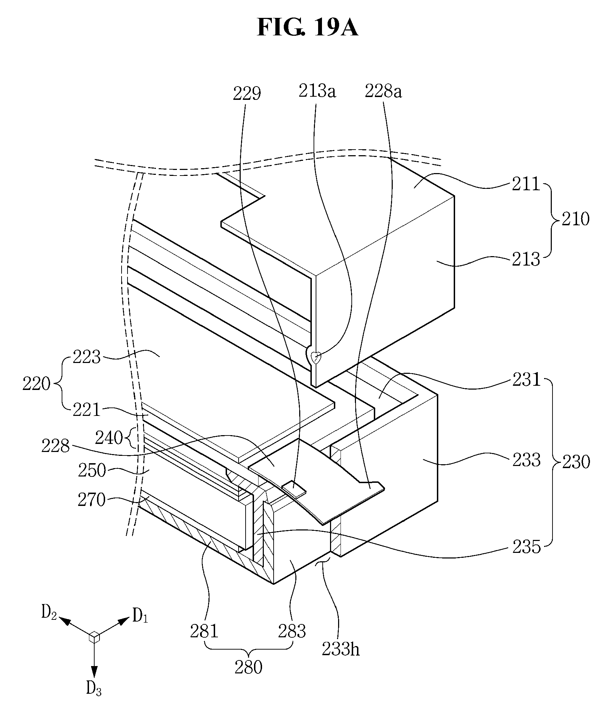

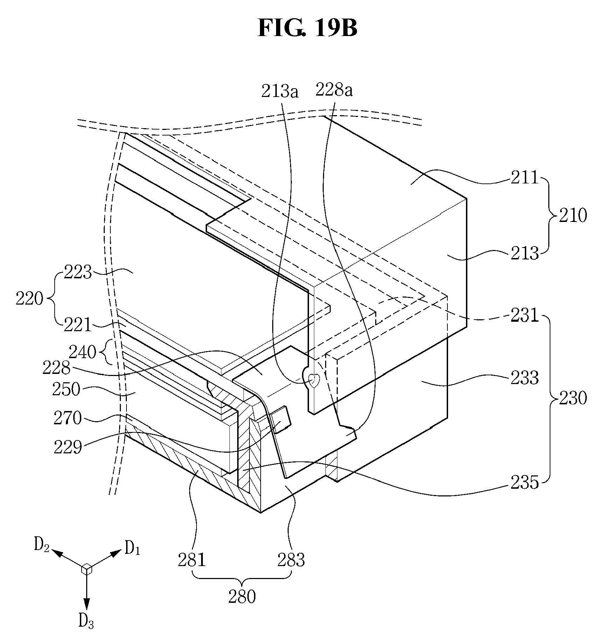

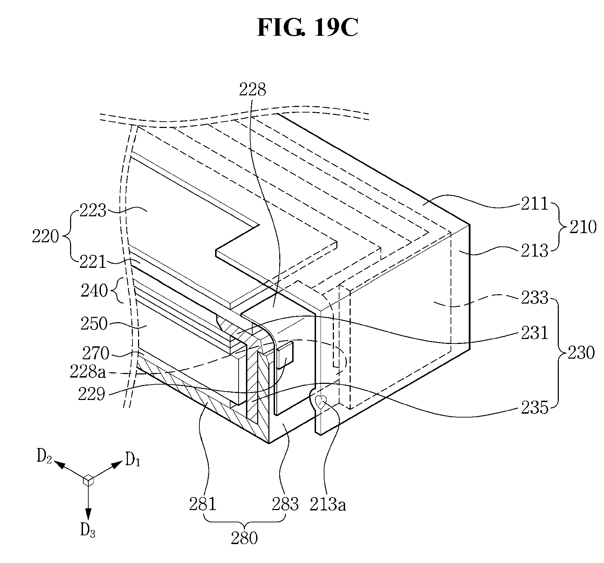

FIGS. 19A through 19C are views illustrating a process of assembling a display device according to another exemplary embodiment of the present invention. A description pertaining to a display device according to another exemplary embodiment including content identical to that included in the description of the display device according to the exemplary embodiment will be omitted for conciseness.

Referring to FIGS. 19A through 19C, the display device according to the other exemplary embodiment may include an upper frame 210, a display panel 220, an intermediate frame 230, an optical sheet 240, a light guide plate 250, a light source unit 260, a reflective sheet 270, and a lower frame 280.

The upper frame 210 may include a bezel portion 211 covering an upper surface of the display panel 220 and a side wall portion 213 bent downwardly from the bezel portion 211 to cover a side surface of the display panel 220. The side wall portion 213 may have one or more bumps 213a formed therein.

The intermediate frame 230 may include a support portion 231 supporting a portion of the display panel 220, a first side wall 233 extending from the support portion 231, and a second side wall 235 extending from the support portion 231 and parallel with respect to the first side wall 233.

The lower frame 280 may include a bottom portion 281 and a side wall portion 283 extending from the bottom portion 281. The side wall portion 283 of the lower frame 280 may be inserted between the first and second side walls 233 and 235 of the intermediate frame 230. The first side wall 233 may be disposed outwardly of the lower frame 280, and the second side wall 235 may be disposed inwardly of the lower frame 280.

The intermediate frame 230 may have an aperture 233h in the first side wall 233, and a second FPCB 228 may be disposed in the aperture 233h and at least a portion of the second FPCB 228 may have a width greater than a width of the aperture 233h. In the display device according to the other exemplary embodiment, an end portion 228a of the second FPCB 228 may have a width greater than the width of the aperture 233h. That is, the end portion 228a of the second FPCB 228 may have a protruding shape.

Referring to FIGS. 19A through 19C, the display panel 220 may be mounted on the support portion 231 of the intermediate frame 230, and the upper frame 210 covering the upper surface and the side surface of the display panel 220 may be coupled to the backlight unit in which the display panel 220 is mounted.

At the time of coupling of the upper frame 210 to the backlight unit, the second FPCB 228 may be pressed down toward the intermediate frame 230 by the bump 213a formed in the side wall portion 213 of the upper frame 210. The second FPCB 228 may be formed of a film material having predetermined elasticity such as a COF or a TCP. Accordingly, when pressed down by the bump 213a, the second FPCB 228 may undergo a temporary elastic deformation to thereby be readily accommodated in a space between the side wall portion 283 of the lower frame 280 and the first side wall 233 of the intermediate frame 230.

Subsequently to the accommodation in the space between the side wall portion 283 of the lower frame 280 and the first side wall 233 of the intermediate frame 230, the end portion 228a of the second FPCB 228 may be restored to an original form thereof to be fixed by the first side wall 233 of the intermediate frame 230.

Since the end portion 228a of the second FPCB 228 is fixed by the first side wall 233 of the intermediate frame 230, during a process of separating the upper frame 210 from the display device for rework, the escape of the second FPCB 228 from the display device along with the upper frame 210 may be prevented.

As set forth above, according to exemplary embodiments of the present invention, the display device may provide a narrow bezel by forming the protrusion in the intermediate frame, and may prevent external impacts or vibrations applied from the upper frame from being directly transmitted to the FPCB.

In the display device according to exemplary embodiments of the present invention, the escape of the FPCB from the display panel due to being caught in the upper frame may be prevented during the process of separating the upper frame from the display device for rework, by forming the protrusion in the intermediate frame and disposing the FPCB inwardly of the protrusion.

In addition, the display device according to exemplary embodiments of the present invention may enhance module assembly process yields, thereby reducing manufacturing costs.

From the foregoing, it will be appreciated that various embodiments in accordance with the present disclosure have been described herein for purposes of illustration, and that various modifications may be made without departing from the scope of the claims. Accordingly, the various embodiments disclosed herein are not intended to be limiting of the scope of the claims. Various features of the above described and other embodiments can be mixed and matched in any manner, to produce further embodiments consistent with the invention.

## Claims

1. A display device comprising:
a display panel (120, 220);
a flexible printed circuit board FPCB (128, 228) attached to the display panel (120, 220); and
an intermediate frame (130, 230) including a support portion (131, 231) supporting the display panel (120, 220) and a first side wall (133, 233) extending from the support portion (131, 231), the intermediate frame (130, 230) having an aperture (133h, 233h) in the first side wall (133, 233) and including at least a protrusion (133a) extending from the first side wall (133, 233) toward the aperture (133h, 233h), and at least a portion of the FPCB (128, 228) is disposed inwardly of the protrusion (133a) and in the aperture (133h, 233h).

2. The display device of claim 1, wherein the protrusion (133a) has a thickness less than a thickness of the first side wall (133, 233).

3. The display device of one of claims 1 or 2, wherein the protrusion (133a) is disposed in the same plane as an outer surface of the first side wall (133, 233).

4. The display device of one of claims 1 or 2, wherein the protrusion (133a) is disposed in a different plane from an outer surface of the first side wall (133, 233).

5. The display device of claim 4, wherein the protrusion (133a) is parallel with respect to the outer surface of the first side wall (133, 233).

6. The display device of claim 4, wherein the protrusion (133a) has a predetermined angle with respect to the outer surface of the first side wall (133, 233).

7. The display device of one of claims 1 to 6, wherein the protrusion (133a) contacts the FPCB (128, 228).

8. The display device of claim 1, wherein the protrusion (133a) extends from the support portion (131, 231) and the first side wall (133, 233) toward the aperture (133h, 233h).

9. The display device of one of claims 1 to 8, wherein the intermediate frame (130, 230) further includes a second side wall (135, 235) extending from the support portion (131, 231) and disposed more inwardly of the intermediate frame (130, 230) than the first side wall (133, 233).

10. The display device of claim 9, further comprising a lower frame (180, 280) disposed between the first and second side walls (133, 233, 135, 235).

11. The display device of one of claims 1 to 10, wherein the FPCB (128, 228) has a width less than a width of the aperture (133h, 233h).

12. The display device of one of claims 1 to 11, wherein the protrusion (133a) has a shape of one selected from the group consisting of a latch shape, a barb shape, a triangular shape, a trapezoidal shape, and a pentagonal shape.

13. The display device of one of claims 1 to 12, wherein at least a portion of the protrusion (133a) is chamfered.

14. The display device of one of claims 1 to 13, wherein at least a portion of the protrusion (133a) has a curved surface.

15. The display device of one of claims 1 to 14, wherein the intermediate frame (130, 230) includes at least a pair of protrusions (133a) extending from the first side wall (133, 233) toward the aperture (133h, 233h) while opposing one another.

16. The display device of one of claims 1 to 15, further comprising an upper frame (110, 214) including a bezel portion (111, 211) covering an upper surface of the display panel (120, 220) and a side wall portion (113, 213) extending downwardly from the bezel portion (111, 211) to cover a side surface of the display panel (120, 220).

17. The display device of claim 16, wherein the upper frame (110, 214) includes at least a bump (113a, 213a) extending from the side wall portion (113, 213) toward the intermediate frame (130, 230).

18. The display device of claim 17, wherein the bump (113a, 213a) is disposed in an area of the upper frame (110, 214) corresponding to the FPCB (128, 228).

19. The display device of one of claims 17 or 18, wherein the bump (113a, 213a) is disposed in an area of the upper frame (110, 214) corresponding to the aperture (133h, 233h).

20. The display device of one of claims 17 to 19, wherein the bump (113a, 213a) has a thickness that is the same as a thickness of the protrusion (133a).

21. The display device of one of claims 17 to 19, wherein the bump (113a, 213a) has a thickness greater than a thickness of the protrusion (133a).

22. The display device of one of claims 17 to 21, wherein the bump (113a, 213a) is in contact with the FPCB (128, 228).

23. The display device of one of claims 17 to 22, wherein the upper frame (110, 214) includes a pair of bumps (113a, 213a) for each FPCB (128, 228), and the bumps (113a, 213a) of a pair of bumps (113a, 213a) are spaced apart from one another by a distance less than the width of the FPCB (128, 228) and are spaced apart from one another by a distance greater than a width of an integrated circuit mounted on the FPCB (128, 228).

24. A display device comprising:
a display panel (120, 220);
a flexible printed circuit board FPCB (128, 228) attached to the display panel (120, 220);
an intermediate frame (130, 230) including a support portion (131, 231) that supports the display panel (120, 220), a first side wall (133, 233) extending from the support portion (131, 231), and a second side wall (135, 235) extending from the support portion (131, 231) and disposed more inwardly from the intermediate frame (130, 230) than the first side wall (133, 233); and
a lower frame (180, 280) disposed between the first and second side walls (133, 233, 135,235),
wherein the intermediate frame (130, 230) has an aperture (133h, 233h) in the first side wall (133, 233), at least a portion of the FPCB (128, 228) is disposed in the aperture (133h, 233h), and the lower frame (180, 280) includes a protrusion (133a) having a hook shape extending toward the aperture (133h, 233h).

25. The display device of claim 24, wherein at least a portion of the protrusion (133a) is parallel with respect to an outer surface of the first side wall (133, 233).

26. A display device comprising:
a display panel (120, 220);
a flexible printed circuit board FPCB (128, 228) attached to the display panel (120, 220); and
an intermediate frame (130, 230) including a support portion (131, 231) that supports the display panel (120, 220) and a first side wall (133, 233) extending from the support portion (131, 231), the intermediate frame (130, 230) having an aperture (133h, 233h) in the first side wall (133, 233), the FPCB (128, 228) being disposed in the aperture (133h, 233h), and at least a portion of the FPCB (128, 228) having a width greater than a width of the aperture (133h, 233h).

27. The display device of claim 26, wherein the intermediate frame (130, 230) further includes a second side wall (135, 235) extending perpendicularly from the support portion (131, 231) and disposed more inwardly of the intermediate frame (130, 230) than is the first side wall (133, 233).

28. The display device of claim 27, further comprising a lower frame (180, 280) disposed between the first and second side walls (133, 233, 135, 235).

29. The display device of claim 28, wherein at least a portion of the FPCB (128, 228) is disposed between the first side wall (133, 233) and the lower frame (180, 280).
